# EUROPÄISCHE PATENTANMELDUNG

(11) **EP 2 251 450 A1**
(43) Veröffentlichungstag der Anmeldung: **17.11.2010**
(21) Anmeldenummer: 10162080.5
(22) Anmeldetag: 06.05.2010
(51) Int. Cl.: C23C 10/14, C23C 10/26, C23C 16/02, C23C 16/20, C23C 16/56, C23C 28/02, C23C 30/00, C25D 5/10, C25D 5/50

(54) **Verfahren zum Aufbringen einer viellagigen Schichtstruktur auf ein Substrat sowie Substrat mit einer viellagigen Schichtstruktur**

(30) Priorität: 06.05.2009 DE 102009002868
(71) Anmelder: InnCoa GmbH, 93333 Neustadt (DE)
(72) Erfinder: Oberhauser, Simon, 85296, Rohrbach (DE); Heller, Dr. Jörg, 51776, Engelskirchen (DE)
(74) Vertreter: Bergmeier, Werner

(57) **Zusammenfassung**

Ein Substrat (1) mit einer metallischen Oberfläche (2) weist eine auf dieser angeordnete viellagige Schichtstruktur (3) aus wenigstens zwei unterschiedlichen Lagen (4, 5) auf, welche in periodisch wiederholter Abfolge aufeinander und parallel zur Oberfläche (2) des Substrats (1) angeordnet sind. Die Schichtstruktur (3) ist als Diffusionsschicht ausgebildet wobei ersten Lagen (4) eine intermetallische Matrix bilden, in welcher Lagen (5) aus wenigstens einer zweiten, vorzugsweise intermetallischen Phase periodisch ausgebildet sind. Bei einem Verfahren zur Herstellung einer viellagigen Schichtstruktur (3) aus wenigstens zwei unterschiedlichen Lagen (4, 5) auf einer metallischen Oberfläche (2) eines Substrats (1) wird auf die Oberfläche (2) des Substrats (1) wenigstens eine metallische Schicht (6) aufgebracht. Zugleich oder anschließend wird das beschichtete Substrat (1) einer Wärmebehandlung unterzogen und die viellagige Schichtstruktur (3) während der Wärmebehandlung durch Diffusion erzeugt. Die Werkstoffe der metallischen Schicht (6) und der Oberfläche (2) des Substrats werden hierbei derart aufeinander abgestimmt, dass durch die Wärmebehandlung erste Lagen (4) als intermetallische Matrix erzeugt werden, in welcher Lagen (5) aus wenigstens einer zweiten, vorzugsweise intermetallischen Phase periodisch ausgebildet werden.

## Beschreibung

Die vorliegende Erfindung betrifft ein Substrat mit einer metallischen Oberfläche und einer auf dieser angeordneten viellagigen Schichtstruktur. Die Schichtstruktur besteht aus wenigstens zwei unterschiedlichen Lagen, welche in periodisch wiederholter Abfolge aufeinander und parallel zur Oberfläche des Substrats angeordnet sind. Weiterhin betrifft die Erfindung ein Verfahren zur Herstellung einer viellagigen Schichtstruktur auf einer metallischen Oberfläche eines Substrates.

Im Stand der Technik sind verschiedene Verfahren bekannt, um Beschichtungen auf Substrate aufzubringen und hierdurch verschiedene, mehrlagige Schichtstrukturen zu erzielen. Die DE 693 25 558 T2 beschreibt beispielsweise ein Verfahren zur Erzeugung eines Aluminid-Silicid-Überzugs auf einem Superlegierungssubstrat, bei welchem der fertige Überzug mehrere Bänder angereichert mit Silizium und mehrere Bänder angereichert mit Aluminium aufweisen soll. Der fertige Überzug weist somit einen mehrschichtigen Aufbau auf. Zur Herstellung des mehrschichtigen Aufbaus muss jedoch der Beschichtungsvorgang sowie eine anschließende Diffusionswärmebehandlung zur Erzeugung der Aluminide und Silicide mehrfach wiederholt werden.

Weiterhin ist es bekannt, mehrlagige Beschichtungen aus unterschiedlichen Hartstoffen als Verschleißschutzschichten auf metallische Oberflächen, beispielsweise zur Beschichtung von Werkzeugen, aufzubringen. Hierbei werden beispielsweise abwechselnd Einzellagen bestehend aus einem metallischen Hartstoff und einem kovalenten Hartstoff aufgetragen, um einen vielschichtigen Aufbau zu erzielen. Die DE 35 12 986 und die 195 03 070 C1 beschreiben derartige mehrlagige Hartstoffbeschichtungen.

Die US 5,282,985 beschreibt einen mehrschichtigen Aufbau von Beschichtungen aus Festschmierstoffen. Hier werden ein erster Festschmierstoff und ein zweiter Festschmierstoff abwechselnd auf eine Lageroberfläche aufgetragen.

Ein viellagiger Schichtaufbau mit wechselnder Abfolge wenigstens zweier verschiedener Lagen ist somit im Stand der Technik nur durch ein mehrfaches Wiederholen des Beschichtungsvorganges zu erreichen. Die Auswahl der Beschichtungsverfahren und Beschichtungswerkstoffe, welche zum Aufbringen derartiger viellagiger Schichtstrukturen geeignet sind, sowie die Anwendungsmöglichkeiten derart beschichteter Substrate sind entsprechend eingeschränkt und das Aufbringen der Schichtstruktur ist vergleichsweise aufwendig.

Aufgabe der vorliegenden Erfindung ist es daher, ein Substrat mit einer viellagigen Schichtstruktur aus wenigstens zwei unterschiedlichen Lagen vorzuschlagen, welches weitreichendere Anwendungsmöglichkeiten bietet und vergleichsweise einfach herzustellen ist. Weiterhin soll ein entsprechendes Verfahren vorgeschlagen werden.

Die Aufgabe wird gelöst mit den Merkmalen der unabhängigen Ansprüche.

Ein Substrat weist eine metallische Oberfläche und eine auf dieser angeordnete viellagige Schichtstruktur aus wenigstens zwei unterschiedlichen Lagen auf. Die Lagen sind hierbei in periodisch wiederholter Abfolge aufeinander und parallel zur Oberfläche des Substrates angeordnet. Erfindungsgemäß ist die Schichtstruktur als Diffusionsschicht ausgebildet und weist eine intermetallische Matrix als erste Phase auf, in welcher Lagen aus wenigstens einer zweiten, vorzugsweise intermetallischen Phase periodisch ausgebildet sind. Es wechseln somit erste Lagen aus der intermetallischen Matrix mit Lagen aus einer zweiten Phase ab. Das Substrat kann beispielsweise ein Bauteil sein, welches mit einer Schutzschicht überzogen werden soll, ein Werkstück, ein Halbzeug, welches vor seiner endgültigen Formgebung beschichtet wird oder auch ein beliebiger anderer Gegenstand.

Bei einem Verfahren zur Herstellung einer viellagigen Schichtstruktur aus wenigstens zwei unterschiedlichen Lagen auf einer metallischen Oberfläche eines Substrats wird auf die Oberfläche des Substrates wenigstens eine metallische Schicht aufgebracht und das beschichtete Substrat einer Wärmebehandlung unterzogen und die viellagige Schichtstruktur während der Wärmebehandlung durch Diffusion erzeugt. Die Werkstoffe der metallischen Schicht und der Oberfläche des Substrats werden dabei derart aufeinander abgestimmt, dass durch die Wärmebehandlung Lagen aus einer ersten, intermetallischen Phase als intermetallische Matrix erzeugt werden, in welcher Lagen aus wenigstens einer zweiten, vorzugsweise intermetallischen Phase periodisch ausgebildet werden.

Vorzugsweise wird bei dem erfindungsgemäßen Verfahren zunächst die metallische Schicht aufgebracht und das Substrat anschließend einer gezielten Wärmebehandlung unterzogen. Es liegt jedoch ebenso im Rahmen der Erfindung, das Aufbringen der Schicht und die Wärmebehandlung gleichzeitig durchzuführen. Dies ist beispielsweise durch Aufbringen der Schicht in einem Packverfahren möglich.

Durch die Auswahl entsprechender Werkstoffpaarungen für die Oberfläche des Substrats und die Beschichtung, welche in der Lage sind, eine intermetallische Matrix zu bilden, ist es möglich geworden, einen viellagigen Schichtaufbau durch Aufbringen einer einzigen Schicht mit anschließender, einmaliger Wärmebehandlung zu erzielen. Die Schichtstruktur ist hierbei diffusionsbedingt mit dem Substrat verwachsen, so dass eine besonders gute Haftung erzielt wird. Eine Wiederholung des Beschichtungsvorganges oder der Wärmebehandlung, welche bei Temperaturen ab 400°C durchgeführt wird, oder ein abwechselndes Beschichten mit verschiedenen Beschichtungswerkstoffen ist nicht erforderlich. Zugleich kann trotz der viellagigen Schichtstruktur ein vergleichsweise dünner Aufbau der Schichtstruktur erzielt werden, welcher die günstigen Eigenschaften eines alternierenden Schichtaufbaus aufweist. Die Haftung sowohl der einzelnen Lagen untereinander sowie der viellagigen Schichtstruktur auf der Oberfläche ist im Vergleich zu einer Schichtstruktur, bei welcher nacheinander mehrere Schichten aufgebracht wurden, durch die innige diffusive Verbindung wesentlich verbessert.

Durch die Ausbildung einer intermetallischen Matrix kann ein vergleichsweise harter und somit verschleißfester und chemisch beständiger Überzug erzielt werden. Da die intermetallische Matrix von Lagen der zweiten Phase abwechselnd durchsetzt ist, können je nach Wahl des Grundmaterials und des Beschichtungswerkstoffes die Eigenschaften der viellagigen Schichtstruktur eingestellt werden.

So können beispielsweise härtere Lagen mit zäheren Lagen abwechseln, um günstige Eigenschaften hinsichtlich Haftung oder Aufnahme von unterschiedlichen Spannungen bzw. Dehnungen der Schichtstruktur bei Belastung zu erzielen. Vorzugsweise sind die Lagen der zweiten Phase ebenfalls intermetallisch ausgebildet, so dass die gesamte Schichtstruktur eine vergleichsweise große Härte aufweist. Besonders vorteilhaft ist es hierbei, dass im Gegensatz zu bekannten Beschichtungsverfahren der viellagige Schichtaufbau auch an Kanten oder in Vertiefungen des Substrats gleichmäßig ausgebildet wird.

Vorzugsweise wird für die Werkstoffe der metallischen Schicht und des Substrates oder der Oberfläche des Substrates eine Paarung aus Nickel-Wolfram oder Nickel-Molybdän oder Nickel-Molybdän-Wolfram und Aluminium ausgewählt. Wird ein entsprechendes Substrat ausgewählt und mit dem gewählten Beschichtungswerkstoff beschichtet, so entsteht durch die Diffusionsbehandlung eine intermetallische Phase aus Aluminium-Nickel, insbesondere aus Al₃Ni und/oder aus Al₃Ni₂ als Matrix. Als zweite Phase werden in der intermetallischen Matrix aus Aluminium-Nickel Lagen aus einer Aluminium-Wolfram- oder Aluminium-Molybdän-Verbindung, insbesondere aus Al₄W gebildet, je nachdem, ob Nickel-Wolfram oder Nickel-Molybdän verwendet wurde. Auch hier können mehrere intermetallische Phasen bestehen, welche die Lagen in der Matrix aus Aluminium-Nickel ausbilden.

Je nach Auswahl der Werkstoffe der metallischen Schicht und des Substrates oder der Oberfläche des Substrates können jedoch sowohl die Lagen der Matrix wie auch die Lagen der zweiten Phase aus ternären Verbindungen von Al-Ni-Mo oder Al-Ni-W oder auch aus quaternären Verbindungen von Al-Ni-Mo-W bestehen.

Durch den erfindungsgemäßen Aufbau der viellagigen Schichtstruktur mit einer intermetallischen Matrix, in welcher die Lagen aus der zweiten Phase angeordnet sind, kann ein stabiler Schichtaufbau erzeugt werden, welcher auch über einen langen Zeitraum oder bei Temperatureinflüssen äußerst stabil ist. Im Gegensatz hierzu neigen die Schichtstrukturen des Standes der Technik unter Temperatureinflüssen oder längerer Zeitdauer zum Degradieren.

Um die Eigenschaften der viellagigen Schichtstruktur beeinflussen zu können, kann die Zeitdauer der Wärmebehandlung abgestimmt werden. So kann die Wärmebehandlung beispielsweise über einen längeren Zeitraum durchgeführt werden, wobei die Lagen der Matrix aus einer einzigen intermetallische Phase, vorzugsweise Al₃Ni₂, bestehen, in welcher wiederum die Lagen aus Aluminium-Wolfram oder Aluminium-Molybdän angeordnet sind. Es ist jedoch auch gezielt möglich, die Wärmebehandlung nur über einen kürzeren Zeitraum durchzuführen, wobei dann die Lagen der intermetallischen Matrix aus zwei verschiedenen Phasen, vorzugsweise Al₃Ni₂ und Al₃Ni, bestehen. Die Lagen der Matrix aus den verschiedenen Phasen sind hierbei bedingt durch den Ablauf der Diffusionsvorgänge in unterschiedlichen Abständen zum Substrat angeordnet. Durch die Auswahl der Werkstoffpaarung des Beschichtungsmaterials und der Oberfläche des Substrats sowie eine geeignete Wahl der Zeitdauer der Wärmebehandlung kann somit sowohl die Anordnung der Phasen der Matrix in Bezug auf die Oberfläche des Substrats sowie der Schichtaufbau von Innen nach Außen beeinflusst werden. So kann beispielsweise erreicht werden, dass eine Phase der Matrix mit einer größeren Härte außen angeordnet ist und eine Matrix mit geringerer Härte zwischen dem Substrat und der äußeren Phase.

Weiterhin vorteilhaft ist es, wenn die Lagen aus der zweiten Phase im wesentlichen äquidistant innerhalb der Matrix oder innerhalb einer Phase der Matrix ausgebildet sind. Wird eine Werkstoffpaarung aus Nickel-Wolfram oder Nickel-Molybdän oder Nickel-Molybdän-Wolfram und Aluminium ausgewählt, so werden beispielsweise in einer Matrix aus Al₃Ni₂ die Lagen aus Al₄W in regelmäßigen Abständen von etwa 2µm ausgebildet. In einer Matrix aus Al₃Ni sind hingegen die Lagen aus Al₄W in größeren Abständen angeordnet. Die Lagen der Matrix aus Al₃Ni weisen entsprechend eine etwas größere Dicke auf.

Um einen erfindungsgemäßen viellagigen Schichtaufbau herzustellen, wird die Wärmebehandlung bei einer Temperatur von 400C° bis 1000 C°, vorzugsweise bei 600C° durchgeführt.

Nach einer vorteilhaften Weiterbildung der Erfindung kann die Wärmebehandlung auch durch die Prozesswärme eines Herstellprozesses erfolgen. Beispielsweise kann die wenigstens eine metallische Schicht während eines Heissumformprozesses aufgetragen werden. Ebenso kann die metallische Schicht nach einem Herstellprozess, bei welchem das Substrat wärmebeaufschlagt wurde, auf die noch heiße Oberfläche des Substrats aufgetragen werden.

Nach einer anderen vorteilhaften Weiterbildung kann das Substrat auch ein Bauteil sein, welches im Betrieb wärmebeaufschlagt ist. Beispielsweise kann es sich um ein im Betrieb heißgas- oder heißmedienbeaufschlagtes Bauteil handeln, oder das Bauteil kann durch Prozesswärme angrenzender bzw. benachbarter Bauteile wärmebeaufschlagt sein. Das Substrat wird in diesem Fall nach seiner Herstellung beschichtet und in Betrieb genommen, wobei die Wärmebehandlung dann durch die Prozesswärme im Betrieb erfolgt.

Bei einem entsprechend hergestellten Substrat mit einer viellagigen Schichtstruktur weisen die Lagen der Matrix eine Dicke zwischen 0,05 und 3 µm, vorzugsweise zwischen 0,4 und 0,8 µm auf. Beispielsweise können bei einer Matrix aus Al₃Ni₂ die Lagen eine Dicke zwischen 0,05 und 0,8 µm aufweisen, während die Lagen aus Al₃Ni eine größere Dicke von beispielsweise 0,2 bis 3 µm aufweisen.

Weiterhin ist es vorteilhaft, wenn die Lagen der Matrix eine Härte von etwa 350 HV - 1100 HV aufweisen. Bei einer Matrix aus Al₃Ni weisen die Lagen vorzugsweise eine Härte von etwa 600 - 700 HV auf, während bei einer Matrix aus Al₃Ni₂ die Lagen eine Härte von etwa 1000 - 1100 HV aufweisen. Die Lagen aus Aluminium-Wolfram oder Aluminium-Molybdän weisen hingegen eine Härte von etwa 650-1000 HV und eine Dicke zwischen 0,05 und 2 µm, vorzugsweise zwischen 0,1 und 0,8 µm auf. Die Dicke der Lagen bzw. die Ausbildung verschiedener Phasen der Matrix mit verschiedenen Dicken wird wie beschrieben durch die Zeitdauer der Wärmebehandlung bestimmt, wobei die Lagen aus Aluminium-Wolfram in einer Matrix Al₃Ni eine größere Dicke haben als in einer Matrix Al₃Ni₂.

Nach einer ersten vorteilhaften Ausführung der Erfindung wird als Substrat eine Aluminiumlegierung ausgewählt, auf das Substrat eine Schicht aus Nickel-Wolfram oder Nickel-Molybdän oder Nickel-Molybdän-Wolfram aufgebracht und anschließend das beschichtete Substrat einer Wärmebehandlung unterzogen. Bei einem entsprechenden Substrat kann der Grundwerkstoff aus Aluminium oder einer Aluminiumlegierung bestehen oder das Substrat kann eine Aluminiumbeschichtung als Oberfläche aufweisen. Hierdurch kann eine Oberflächenhärtung eines Substrats und eine Erhöhung der chemischen Beständigkeit hinsichtlich des pH-Wertes erzielt werden.

Nach einer anderen Weiterbildung der Erfindung wird als Substrat ein Stahlwerkstoff ausgewählt, auf das Substrat eine erste Schicht aus Nickel-Wolfram oder Nickel-Molybdän oder Nickel-Molybdän-Wolfram und eine zweite Schicht aus Aluminium aufgebracht. Anschließend wird das beschichtete Substrat der Wärmebehandlung unterzogen. Hierdurch entsteht auf einem Substrat aus Stahl ein viellagiger Aufbau, bei welchem Phasen aus Aluminium-Nickel und Aluminium-Wolfram oder Aluminium-Molybdän wechselnd aufgebracht sind. Hierdurch kann beispielsweise eine Oxidationsschutzschicht, eine Schutzschicht gegen aggressive Chemikalien/Medien, wie H₂S, Ammoniak, chloridhaltige Stoffe sowie die Zersetzungsprodukte der vorausgenannten Stoffe und gegen Metall dusting auf niedrig legierten Stählen erreicht werden. Diese weist im Vergleich zu anderen Oxidationsschutzschichten eine hohe Langzeitstabilität auf, da sich im Vergleich zu anderen Systeme eine Wolfram-reiche bzw. Molybdän-reiche Interdiffusionsbarriere zwischen Substrat und Aluminiumdiffusionsauflageschicht ausbildet. Die Oxidationsschutzschichten sind hierbei bis 870 C° einsetzbar.

Ferner bewirkt die erzeugte neue Oberfläche bei Stahl und Ni-Basiswerkstoffen neben der Erhöhung von verschiedensten Korrosionsbeständigkeiten noch eine Erhöhung der Verschleißbeständigkeit, bedingt durch die höheren Härten von Matrix und/oder Lagen.

Nach einer besonders vorteilhaften Weiterbildung der Erfindung wird auf das Substrat eine erste Schicht aus Nickel-Wolfram oder Nickel-Molybdän oder Nickel-Molybdän-Wolfram und eine zweite Schicht aus Aluminium aufgebracht und das Substrat nach dem Beschichten einer Heißumformung unterzogen. Die viellagige Schichtstruktur wird hierbei vorteilhafterweise bereits während der während der Heißumformung erzeugt, so dass eine gesonderte Diffusionsbehandlung nicht erforderlich ist. Hierdurch ist es möglich, ähnlich dem Usibor-Verfahren eine Härtung des Substrats bzw. eines Bauteils auf vergleichsweise einfache Art und Weise zu erzielen. Ein derartiges Verfahren kann sowohl für den normalen Korrosionsschutz oder als Beschichtung für hochfesten Stahl, beispielsweise in der Automobilindustrie im Crashbereich eingesetzt werden.

Nach einer anderen Weiterbildung der Erfindung wird als Substrat eine Nickelbasislegierung mit einem Anteil an Wolfram und/oder Molybdän gewählt, auf das Substrat eine Aluminiumschicht aufgebracht und anschließend das beschichtete Substrat der Wärmebehandlung unterzogen. Die Oberfläche des Substrats und/oder das Substrat besteht hierbei aus einer Nickelbasislegierung mit einem Anteil an Wolfram oder Molybdän. Ein Substrat mit einer derartigen Beschichtung kann beispielsweise in der Chemischen Industrie bzw. Petrochemie oder der Luftfahrt sowie der Energietechnik eingesetzt werden. Die Schichtstruktur bildet hier eine Schutzschicht gegen aggressive Chemikalien und Medien, wie H₂S, Ammoniak, chloridhaltige Stoffe sowie deren Zersetzungsprodukte und gegen Metall dusting. Weiterhin bildet die Schichtstruktur eine Interdiffusionsbarriere für Aluminium zur Vermeidung eines Aluminium-Eintrags ins Substrat.

Wesentlich für die Ausführung des erfindungsgemäßen Verfahrens ist es somit, ein System vorzusehen, welches die Werkstoffe Nickel-Wolfram oder Nickel-Molybdän bzw. Nickel-Molybdän-Wolfram und Aluminium beinhaltet. Einer dieser Werkstoffe kann hierbei das Substrat bilden, während der andere als Beschichtungswerkstoff auf dieses Substrat aufgebracht wird. Ebenso ist es jedoch möglich, ein Substrat aus einem anderen Werkstoff nacheinander mit den beiden Werkstoffen des Beschichtungssystems zu beschichten und der Wärmebehandlung zu unterziehen.

Zum Aufbringen der metallischen Schicht sind verschiedene Verfahren möglich. Eine Schicht aus Nickel-Wolfram oder Nickel-Molybdän wird vorzugsweise galvanisch und vorzugsweise in einer Schichtstärke von ca. 10-60 µm, insbesondere 15-30 µm auf das Substrat aufgebracht. Mittels einer derartigen Schichtstärke lässt sich ein günstiger Schichtaufbau mit einer Vielzahl von Schichten erzielen. Ebenso lässt sich eine Nickel-Molybdän-Wolfram-Schicht galvanisch aufbringen, wozu ggf. in aufeinander folgenden Schritten jeweils eine binäre Beschichtung aufgebracht wird.

Weiterhin ist es vorteilhaft, die Aluminiumschicht in einem galvanischen oder einem MOCVD-Verfahren vorzugsweise in einer Schichtstärke von wenigstens 15 µm aufzubringen, um den gewünschten viellagigen Schichtaufbau zu erzielen. Andere Verfahren sind jedoch ebenfalls möglich. Denkbar ist auch das Aufbringen der Schicht in einem PVD-, IVD- oder lonic-Liquid-Verfahren, wobei jeweils eine anschließende Wärmebehandlung durchgeführt wird. Ebenso möglich ist ein Aufbringen der wenigstens einen Schicht in einem Pulverpack- bzw. Out-of-Pack-Verfahren. Die Diffusion und Lagenausbildung erfolgt hierbei simultan mit dem Al-Auftrag, so dass keine gesonderte Wärmebehandlung erforderlich ist. Weiterhin ist es möglich, die Schicht durch Walzplattieren oder Schmelztauchen aufzubringen.

Die Dicke der viellagigen Schichtstruktur beträgt nach der Diffusionsbehandlung beispielsweise zwischen 10 µm und 100 µm, vorzugsweise ca. 10-40 µm. Ist beispielsweise auf ein Stahlsubstrat zunächst eine Schicht aus Nickel-Wolfram aufgebracht, so kann die Gesamtschichtdicke auf dem Stahlsubstrat beispielsweise zwischen 20 und 100 µm betragen.

Weitere Vorteile der Erfindung werden anhand der nachfolgend dargestellten Ausführungsbeispiele beschrieben. Es zeigen:
- **Figur 1**: Eine schematische Darstellung der Herstellung der erfindungs- gemäßen viellagigen Schichtstruktur auf einer metallischen Oberfläche aus Nickel-Wolfram,
- **Figur 2**: eine schematische Darstellung der Herstellung der erfindungs- gemäßen viellagigen Schichtstruktur auf einem Aluminiumsub- strat,
- **Figur 3**: eine elektronenmikroskopische Darstellung eines erfindungsge- mäßen Substrats mit einer viellagigen Schichtstruktur, sowie
- **Figur 4**: eine weitere schematische Darstellung einer erfindungsgemäßen viellagigen Schichtstruktur auf einer metallischen Oberfläche aus Nickel-Molybdän.

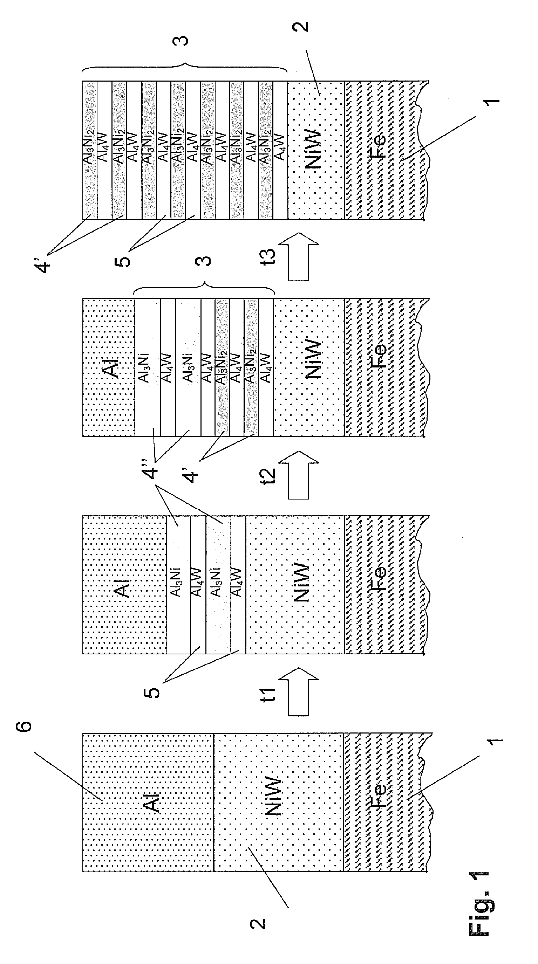

Figur 1 zeigt ein erfindungsgemäßes Substrat 1 mit einer metallischen Oberfläche 2 sowie eine auf dieser angeordnete viellagige Schichtstruktur 3, welche aus zwei unterschiedlichen Lagen 4 und 5 besteht, die in periodisch wiederholter Abfolge aufeinander und parallel zur Oberfläche des Substrats 1 angeordnet sind. Die rechts angeordnete Darstellung der Figur 1 zeigt hierbei das erfindungsgemäße Substrat 1 mit viellagiger Schichtstruktur 3 nach der Wärmebehandlung mit der Zeitdauer t3, während die linke Darstellung das Substrat 1 bzw. die Oberfläche 2 mit einer darauf aufgebrachten metallischen Schicht 6 vor der Wärmebehandlung zeigt. Die Darstellungen zwischen den beiden genannten zeigen jeweils verschiedene Zwischenstufen der viellagigen Schichtstruktur nach Ablauf einer bestimmten Zeitspanne t1 bzw. t2 während der Wärmebehandlung bzw. während des Diffusionsprozesses.

Zur Herstellung der viellagigen Schichtstruktur wurde im vorliegenden Beispiel ein Substrat 1 aus einem Stahlmaterial mit einer Nickel-Wolfram-Beschichtung versehen, welche vorliegend die metallische Oberfläche 2 des Substrats 1 bildet. Die Nickel-Wolfram-Schicht wird hierbei in einem galvanischen Verfahren in einer Stärke zwischen etwa 10-40 µm, vorzugsweise 15 µm aufgebracht und enthält einen Wolframanteil von etwa 30-40 %. Auf die Nickel-Wolfram-Schicht 2 wird anschließend als metallische Schicht 6 eine Reinaluminiumschicht in einer Schichtstärke von wenigstens 15 µm aufgebracht. Auch die Aluminiumschicht 6 kann galvanisch aufgebracht werden, ebenso ist es jedoch auch möglich, die Schicht 6 aus Reinaluminium in einem MOCVD-Verfahren (metallorganic chemical vapour deposition) aufzubringen. Versuche der Anmelderin haben hierbei ergeben, dass das Beschichtungsverfahren (galvanisch oder MOCVD) keinen wesentlichen Einfluss auf Eigenschaften der viellagigen Schichtstruktur 3 wie beispielsweise Härte und E-Modul hat.

Nach dem Aufbringen der Schicht 6 wird das beschichtete Substrat 1 einer Wärmebehandlung unterzogen, um die gewünschte, rechts dargestellte viellagige Schichtstruktur 3 durch Diffusion zu erzeugen. Das Substrat wird hierbei über einen Zeitraum von beispielsweise 3 Stunden einer Wärmebehandlung unter Normalatmosphäre und Normaldruck bei 600 C° unterzogen. Hierbei wird bei geeigneter Auswahl der beteiligten Werkstoffe eine Schichtstruktur 3 erzielt, bei welcher Lagen 4 und 5 aus wenigstens zwei unterschiedlichen Phasen abwechselnd aufeinander und parallel zur Oberfläche gebildet werden. Im Gegensatz hierzu ist es bei Beschichtungen des Standes der Technik, welche anschließend einer Diffusionsbehandlung unterzogen wurden, lediglich möglich, eine Legierungszone zwischen der Oberfläche des Substrats und der aufgebrachten Schicht zu erzeugen.

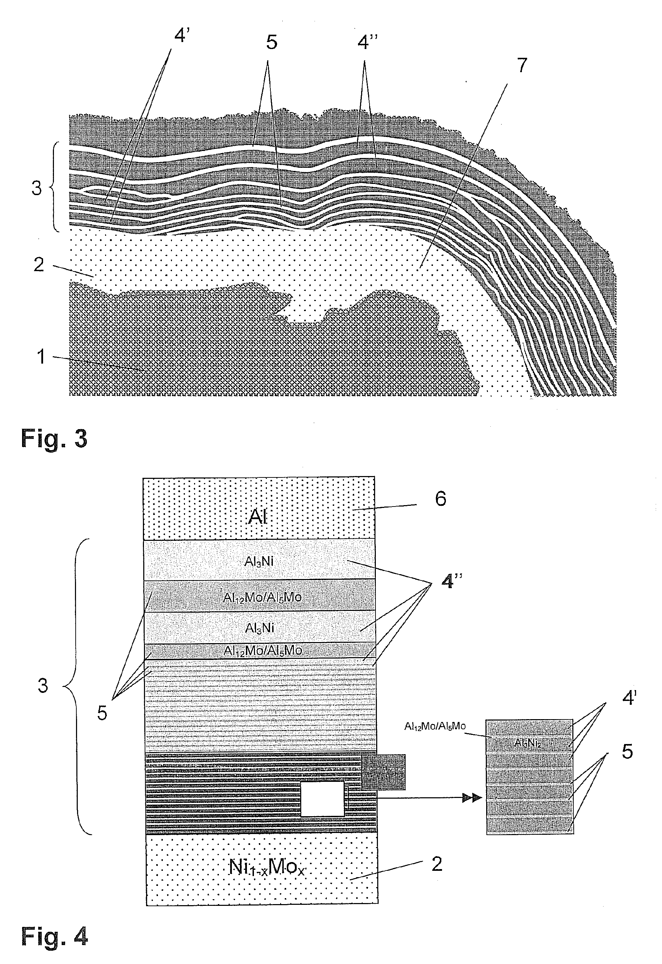

Wie in Figur 3 ersichtlich, wird die erfindungsgemäße Schichtstruktur 3 hierbei auch regelmäßig um Kanten des Substrats 1 ausgebildet, so dass mittels des erfindungsgemäßen Verfahrens im Gegensatz zu einigen Beschichtungsverfahren des Standes der Technik eine völlig regelmäßige viellagige Schichtstruktur 3 auch über Kanten oder in Vertiefungen bzw. bei komplizierten Geometrien des Substrats 1 ausgebildet werden kann.

Wie in der Darstellung ganz rechts gezeigt, werden durch die Diffusionsbehandlung Lagen 4 aus Al₃Ni₂ im Wechsel mit Lagen 5 aus Al₄W ausgebildet. Die Lagen 4 bilden eine intermetallische Matrix, in welcher Lagen 5 aus einer zweiten intermetallische Phase, vorliegend Al₄W, angeordnet sind. Die Lagen 4, 5 werden hierbei senkrecht zur Diffusionsrichtung und parallel zur Oberfläche des Substrats bzw. parallel zur Grenzschicht zwischen den Schichten aus Nickel-Wolfram und Aluminium ausgebildet. Versuche der Anmelderin, bei welchen beschichtete und wärmebehandelte Substrate mit verschiedenen Kühlmethoden und verschiedenen Abkühlgeschwindigkeiten gekühlt bzw. abgeschreckt wurden, ergaben, dass die Abkühlgeschwindigkeit keinen erkennbaren Einfluss auf die Ausbildung der Schichtstruktur 3 hat. Auch die Dicken der Lagen 4, 5 der einzelnen Phasen sowie die Abstände der Lagen 5 aus Al₄W blieben im Wesentlichen konstant und zeigten keinen Zusammenhang mit der Abkühlgeschwindigkeit. Die erfindungsgemäße viellagige Schichtstruktur 3 wird somit ausschließlich während der Wärmebehandlung durch Diffusionsprozesse erzeugt und ist somit nicht vergleichbar mit der Perlitbildung, die eine starke Abhängigkeit der Abstände bei der Lagenausbildung von der Abkühlgeschwindigkeit aufweist.

Mittels des erfindungsgemäßen Verfahrens kann eine vergleichsweise harte und diffusiv miteinander verwachsene Schichtstruktur 3 mit abwechselnden Lagen 4, 5 in einem einfachen Verfahren auf ein Substrat 1 aufgebracht werden, da dieses lediglich einen einzigen Beschichtungsvorgang mit anschließender Wärmebehandlung benötigt. Die erfindungsgemäße viellagige Schichtstruktur 3 weist aufgrund ihres kompositartigen Aufbaus eine besonders gute Haftung sowohl der Schichten bzw. Lagen untereinander als auch der Schichtstruktur 3 auf dem Substrat 1 bzw. der Oberfläche 2 auf. Abplatzungen, wie sie von herkömmlichen Beschichtungen bekannt sind, treten bei der erfindungsgemäßen Schichtstruktur 3 nicht auf.

Wie weiterhin aus den beiden mittleren Darstellungen der Figur 1 ersichtlich, wird hierbei zu Beginn des Diffusionsprozesses zunächst eine Matrix mit Lagen 4 aus Al₃Ni ausgebildet, in welcher Lagen 5 von Al₄W angeordnet sind. Wird die Wärmebehandlung bereits zu diesem Zeitpunkt abgebrochen, so besteht die intermetallische Matrix bzw. die Lagen 4" aus der einzigen Phase Al₃Ni, welche von Lagen 5 aus einer zweiten Phase aus Al₄W durchzogen ist. Wird hingegen die Wärmebehandlung weitergeführt und der Diffusionsprozess fortgesetzt, so wird wie in der dritten Darstellung der Figur 1 ersichtlich zunächst beginnend an der Grenzfläche zur Nickel-Wolfram-Schicht eine Matrix aus Al₃Ni₂ ausgebildet. Wird der Diffusionsprozess an dieser Stelle unterbrochen, so beinhaltet die intermetallische Matrix bzw. die Lagen 4', 4" zwei verschiedene Phasen. In der intermetallischen Matrix liegen somit Lagen 4' aus Al₃Ni₂ und 4"aus Al₃Ni vor. Wird der Diffusionsprozess weiterhin fortgesetzt, so findet bis zum Ende des Diffusionsprozesses eine vollständige Umwandlung der intermetallischen Matrix in eine einzige Phase statt. Die Lagen 4' der Matrix bestehen dann aus der einzigen Phase Al₃Ni₂.

Wie weiterhin aus der Darstellung der Figur 1 ersichtlich, kann durch die Zeitdauer der Wärmebehandlung die Ausbildung der Lagen 4' und 4" der Matrix sowie der Aufbau der gesamten viellagigen Schichtstruktur 3 wesentlich beeinflusst werden. Wird der Diffusionsprozess vorzeitig unterbrochen, so findet sich in vorliegendem Beispiel als äußerste Schicht eine Reinaluminiumschicht auf dem Substrat. Je nach Dicke der zuvor aufgebrachten Schicht aus Nickel-Wolfram und Zeitdauer der Diffusionsbehandlung kann weiterhin wie vorliegend dargestellt unterhalb des viellagigen Schichtaufbaus 3 noch eine Nickel-Wolfram-Schicht angeordnet sein. Es ist jedoch auch möglich, dass diese Schicht nahezu vollständig aufgebraucht und durch den Diffusionsprozess in die intermetallische Matrix sowie die Lagen aus Al₄W umgewandelt wird.

Elektronenmikroskopische und röntgendiffraktometrische Untersuchungen der Anmelderin haben weiterhin ergeben, dass in den Lagen der intermetallischen Matrix sowie den intermetallischen Lagen aus Al₄W der Gehalt an Nickel und Wolfram jeweils stark unterschiedlich ist. So wechseln Lagen mit einem hohen Nickelgehalt, welche eine intermetallische Matrix aus einer Aluminium-Nickel-Verbindung bilden, mit Lagen mit einem hohen Wolframgehalt ab, welche die Lagen aus Al₄W bilden. Ferner werden noch sehr geringe Anteile an Al₅W röntgenografisch gefunden, die feindispers in der Matrix oder an der Oberfläche der Al₄W-Lagen zu lokalisieren sein dürften. Die erfindungsgemäße Ausbildung der Schichtstruktur 3 mit abwechselnden Lagen kann hierbei mit einem stark unterschiedlichen Diffusionskoeffizienten der beteiligten Elemente Aluminium, Wolfram und Nickel erklärt werden.

Wird wie unter Figur 1 beschrieben zunächst eine metallische Oberfläche 2 und anschließend eine Aluminiumschicht 6 auf ein Stahlsubstrat 1 aufgebracht und dieses anschließend der Wärmebehandlung unterzogen, so kann mit dem erfindungsgemäßen Verfahren beispielsweise eine Oxidationsschutzschicht, Zunderschutzschicht, Heißgaskorrosionsschutzschicht, Schutzschicht gegen Metalldusting, Schutzschicht vor Sulfidierung (H₂S) oder Korrosionsschutzschicht auf niedrig legierten Stählen erzeugt werden. Diese weist im Gegensatz zu anderen bekannten Oxidationsschutzschichten eine hohe Langzeitstabilität auf, da sich eine Wolframreiche Interdiffusionsbarriere zwischen Substrat und dem restlichen Aluminiumdiffusionsschichtaufbau ausbildet, ein Degradieren der Schicht wird somit stark verlangsamt. Die erfindungsgemäße Schichtstruktur 3 ist hierbei bis 870 C° beständig, während herkömmliche Nickel-Aluminium-Schichten bis max. 650 C° beständig sind. Ebenso kann die Schichtstruktur 3 als Sulfidierungsschutz oder Schutz gegen Aufkohlung oder gegen Ammoniakdämpfe sowie deren Zerfallsprodukte und Schutz gegen normale Nasskorrosion eingesetzt werden.

Durch den alternierenden Aufbau aus zwei verschiedenen Lagen 4 und 5 kann weiterhin eine Rissbildung in der Schicht unter Belastung verhindert werden. Die erfindungsgemäße Schichtstruktur 3 weist zudem eine vergleichsweise große Härte auf. Versuche der Anmelderin, in welchen die Härte der einzelnen Lagen 4 und 5 gemessen wurde, ergaben eine Härte der Al₃Ni-Matrix von etwa 620 HV sowie eine Härte von etwa 800 HV für die Al₄W-Phase. Für die direkt auf dem Substrat noch vorhandene Nickel-Wolfram-Schicht wurde eine Härte von 760 HV ermittelt. Die Mischhärte der Matrix und der Lagen 5 betrug im Bereich der Al₃Ni-Matrix 756 HV und im Bereich der Al₃Ni₂ -Matrix 1140 HV.

Weiterhin ist es mit dem erfindungsgemäßen Verfahren wie vorbeschrieben möglich, das Usibor-Verfahren zu ersetzen, bei welchem vorbeschichtete presshärtbare Stähle bzw. Walzprodukte zum Presshärten mit anschließender Höchstfestigkeit in einer Heißpresse umgeformt werden. Hierzu wird eine Nickel-Wolfram-Schicht und darauf eine Aluminiumschicht im Durchlaufverfahren auf ein Stahlband als Substrat 1 aufgetragen. Die metallische Oberfläche 2 des Substrats wird somit durch die zuerst aufgebrachte Nickel-Wolfram-Schicht gebildet. Nachdem Beschichten durchläuft das Substrat 1 bzw. das Stahlband eine Heißumformung, beispielsweise einen Tiefziehprozess o. ä. Durch die aufgebrachte Beschichtung wird während des Warmumformens eine Verzunderung des Bauteiles bzw. des Substrats 1 verhindert, so dass der Herstellprozess vereinfacht werden kann. Zudem wird eine günstige Oberflächenhärte erzielt. Eine Rissbildung ist hingegen bedingt durch die kompositartige Schichtstruktur 3 nicht zu befürchten. Außerdem weisen die so hergestellten Bauteile einen Nasskorrosionsschutz für höchstfeste Stähle, wie er im Automobilbereich gefordert ist, auf.

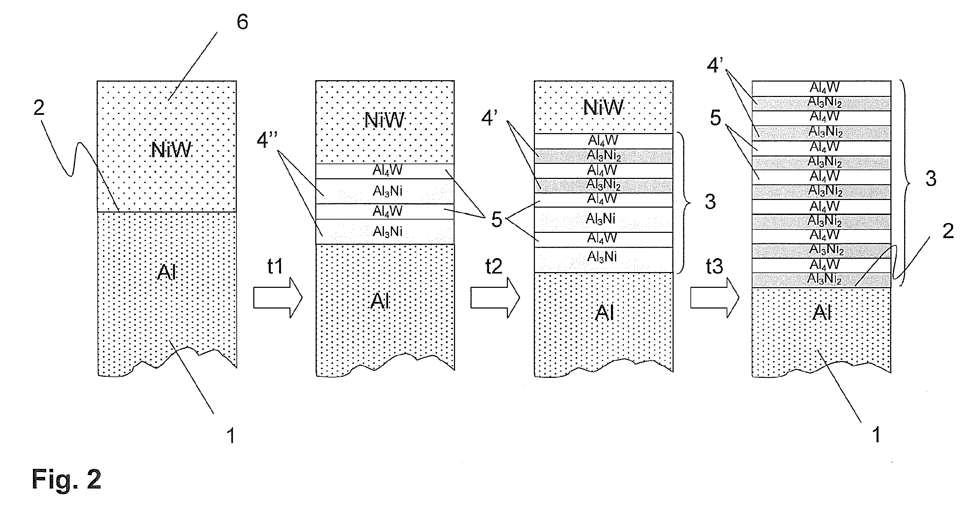

Figur 2 zeigt eine weitere Anwendungsmöglichkeit des erfindungsgemäßen Verfahrens bzw. ein erfindungsgemäßes Substrat mit einer auf diesem angeordneten viellagigen Schichtstruktur 3. Hierbei wird auf ein Substrat 1 bestehend aus einer Aluminiumlegierung eine metallische Schicht 6 aus Nickel-Wolfram wie vorbeschrieben vorzugsweise in einem galvanischen Verfahren und in einer Schichtdicke von beispielsweise 15 µm aufgebracht. Die metallische Oberfläche 2 wird somit direkt durch die Oberfläche des Substrats 1 gebildet. Anschließend wird wie unter Figur 1 beschrieben das beschichtete Substrat 1 einer Wärmebehandlung unterzogen, wobei wiederum unter Durchlaufen bestimmter Zwischenstrukturen schließlich die erfindungsgemäße Schichtstruktur 3 mit wechselnden Lagen Al₄W und Al₃Ni₂ erzielt wird. Je nach Dicke der aufgebrachten Nickel-Wolfram-Schicht sowie Zeitdauer der Diffusionsbehandlung kann hierbei wie in den mittleren Darstellungen der Fig. 2 gezeigt als oberste Schicht oberhalb der alternierenden Schichtstruktur 3 noch eine Schicht aus Nickel-Wolfram angeordnet sein. Es ist jedoch auch möglich, dass die Schicht aus Nickel-Wolfram vollständig aufgebraucht bzw. in der alternierenden Schichtstruktur umgewandelt wurde. Da die abwechselnden Lagen 4 der intermetallischen Matrix aus Al₃Ni₂ und 5 aus Al₄W eine vergleichsweise große Härte aufweisen, kann somit das erfindungsgemäße Verfahren auch vorteilhaft zum Aufhärten von Aluminiumwerkstoffen in der Randzone eingesetzt werden.

Weiterhin ist es natürlich ebenso möglich, ähnlich wie in Figur 1 beschrieben eine einzige metallische Schicht 6 aus Aluminium direkt auf ein Substrat 1 aus einer Nickellegierung mit einem Anteil an Wolfram oder Molybdän aufzubringen. Die metallische Oberfläche 2 des Substrats wird in diesem Fall direkt durch die Oberfläche des Substrats 1 gebildet und nicht wie in Figur 1 dargestellt durch eine auf die Oberfläche des Substrats aufgebrachte metallische Schicht aus Nickel-Wolfram.

Figur 3 zeigt schließlich ein elektronenmikroskopisches Bild einer Schichtstruktur wie unter Figur 1 beschrieben, bei welcher auf ein Stahlsubstrat 1 eine Schicht aus Nickel-Wolfram als metallische Oberfläche 2 sowie eine Schicht 6 aus Aluminium aufgebracht wurde. Wie beschrieben wurde das beschichtete Substrat 1 einer Wärmebehandlung unterzogen wobei vorliegend eine intermetallische Matrix aus Aluminium-Nickel erzeugt wurde, welche zwei verschiedene Phasen bzw. Lagen 4' und 4" umfasst. Wie weiterhin erkennbar sind angrenzend an die Nickel-Wolfram-Schicht Lagen 4' bzw. eine intermetallische Matrix aus einer ersten Phase bestehend aus Al₃Ni₂ ausgebildet, während die Lagen 4" bzw. die Matrix zur äußeren Oberfläche des beschichteten Substrats 1 hin aus einer zweiten Phase aus Al₃Ni bestehen. Innerhalb der intermetallischen Matrix sind in jeweils äquidistanten Abständen die Lagen 5 bestehend aus Al₄W ausgebildet.

Aus Figur 3 ist weiterhin erkennbar, dass die Lagen aus Al₄W innerhalb der ersten Matrix aus Al₃Ni₂ einen geringeren Abstand zueinander aufweisen und etwas dünner ausgebildet sind als in der Matrix aus Al₃Ni. Wie weiterhin gezeigt, erfolgt die Ausbildung der erfindungsgemäßen viellagigen Schichtstruktur 3 sehr gleichmäßig und parallel auch über Kanten 7 des Substrats 1.

Figur 4 zeigt ein weiteres Beispiel eines Aufbaus einer viellagigen Schichtstruktur 3. Hier wurde auf eine metallische Oberfläche 2, welche vorliegend durch eine Nickel-Molybdän-Legierung gebildet ist, eine Reinaluminiumschicht als metallische Schicht 6 analog dem Verfahren bei der in Fig. 1 dargestellten Schichtstruktur 3 aufgebracht. Die metallische Oberfläche 2 aus Nickel-Molybdän kann hierbei als Beschichtung auf ein Substrat 1 aus einem anderen Material aufgebracht sein oder durch die Oberfläche 2 des Substrats selbst, welchen in diesem Fall aus einer Nickel-Molybdän-Legierung besteht, gebildet sein. Das Aufbringen der Aluminiumschicht 6 sowie ggf. der Nickel-Molybdän-Schicht als Oberfläche 2 kann wie bereits anhand der Figuren 1 und 2 beschrieben, in einem galvanischen Verfahren oder einem MOCVD-Verfahren erfolgen. Ebenso ist es, um die gezeigte Schichtstruktur 3 zu erzielen, ebenso möglich, ein Substrat 1 bzw. eine Oberfläche 2 aus Aluminium mit einer Nickel-Molybdän-Beschichtung zu versehen.

Nach dem Aufbringen der Aluminiumschicht 6 wurde das beschichtete Substrat 1 (hier nicht dargestellt) über einen Zeitraum von 3 Stunden einer Wärmebehandlung unter Normalatmosphäre und Normaldruck bei 600 °C unterzogen, wobei die dargestellte Schichtstruktur 3 ausgebildet wurde. Die Schichtstruktur 3 weist, ähnlich wie in der dritten Darstellung der Figur 1, an der Grenzfläche zur Nickel-Molybdän-Schicht eine Matrix mit Lagen 4' aus Al₃Ni₂ auf, während beabstandet zu der Grenzfläche eine Matrix mit Lagen 4" aus Al₃Ni ausgebildet wird. In den Lagen 4', 4" der Matrix sind Lagen 5 aus einer zweiten intermetallischen Phase, hier Al-Mo-Verbindungen, ausgebildet. Vorliegend wurden Lagen 5 aus Al₁₂Mo und Al₅Mo ausgebildet, so daß die Lagen 5 ebenfalls aus zwei intermetallischen Phasen bestehen. Auch hier wurden die Lagen 5 innerhalb einer Phase der Matrix jeweils äquidistant und parallel zur Oberfläche 2 ausgebildet.

Ebenso wie in Fig. 3 weisen die Lagen aus Al₁₂Mo/Al₅Mo innerhalb der ersten Matrix aus Al₃Ni₂ einen geringeren Abstand zueinander auf und sind etwas dünner ausgebildet als in der Matrix aus Al₃Ni. Insgesamt wurden die Lagen 4, 5 sehr dünn und mit sehr geringen Abständen ausgebildet. Lediglich an der Grenzschicht zu der Reinaluminiumschicht 6 weisen die Lagen 4, 5 eine größere Dicke und größere Abstände auf. Die Härte der Schichtstruktur 3 wurde in diesem Fall mit einem Mikrohärteprüfer als Mischhärte, d.h. Härte der Lagen 4 der Matrix und der Lagen 5, ermittelt. Für den Bereich der Matrix aus Al₃Ni₂ ergab sich eine Mischhärte von 1276 HV. Im Bereich der Matrix aus Al₃Ni wurde an der Grenzschicht zu der Reinaluminiumschicht 6, wo die Lagen 4", 5 dicker ausgebildet sind, eine Mischhärte von 456 HV ermittelt, während die näher der Oberfläche 2 gelegenen und wesentlich feiner ausgebildeten Lagen 4", 5 eine Mischhärte von 895 HV aufwiesen.

Mittels des erfindungsgemäßen Verfahrens bzw. des erfindungsgemäßen Substrats mit einer viellagigen Schichtstruktur 3 ist es somit möglich, eine sehr gleichmäßige Beschichtung auch auf komplizierter geformte Geometrien aufzubringen, wobei eine sehr gute Haftung erzielt wird. Zugleich kann durch den viellagigen, alternierenden Schichtaufbau eine Rissbildung weitgehend vermieden werden. Besonders vorteilhaft bei der erfindungsgemäßen Schichtstruktur 3 ist es, dass der Diffusionspartner Wolfram in dem gesamten Beschichtungssystem als Interdiffusionsbarriere wirkt, so dass die erfindungsgemäße Schichtstruktur 3 eine sehr hohe Langzeitstabilität bei vergleichsweise hohen Temperaturen von bis zu 800 °C aufweist. Im Versuch wurde bei einer Temperatur von 700 °C eine Langzeitstabilität von 1000 Stunden nachgewiesen.

In den beschriebenen Ausführungsbeispielen wurden Systeme mit Nickel-Wolfram und Aluminium bzw. mit Nickel-Molybdän und Aluminium beschrieben. Ebenso sind auch ternäre oder quaternäre Systeme mit Al-Ni-W-Verbindungen oder Al-Ni-Mo-Verbindungen bzw. Al-Ni-Mo-W-Verbindungen möglich. Weitere Anwendungsmöglichkeiten, Abwandlungen und Kombinationen im Rahmen der Patentansprüche sind ebenfalls möglich.

## Patentansprüche

1. Substrat (1) mit einer metallischen Oberfläche (2) und einer auf dieser angeordneten viellagigen Schichtstruktur (3), wobei wenigstens zwei unterschiedliche Lagen (4, 5) in periodisch wiederholter Abfolge aufeinander und parallel zur Oberfläche (2) des Substrats (1) angeordnet sind, **dadurch gekennzeichnet, dass** die Schichtstruktur (3) als Diffusionsschicht ausgebildet ist, wobei Lagen (4) aus einer ersten, intermetallischen Phase als Matrix ausgebildet sind, in welcher Lagen (5) aus wenigstens einer zweiten, vorzugsweise intermetallischen Phase periodisch ausgebildet sind.

2. Substrat nach dem vorhergehenden Anspruch, **dadurch gekennzeichnet, dass** die Lagen (4) aus der ersten intermetallischen Phase aus einer Aluminium-Nickel-Verbindung, insbesondere aus Al₃Ni und/oder Al₃Ni₂, bestehen.

3. Substrat nach einem der vorhergehenden Ansprüche, **dadurch gekennzeichnet, dass** die Lagen (5) aus der zweiten Phase aus einer Aluminium-Wolfram- oder Aluminium-Molybdänverbindung, insbesondere aus Al₄W, bestehen.

4. Substrat nach einem der vorhergehenden Ansprüche, **dadurch gekennzeichnet, dass** die intermetallischen Phasen der Lagen (4) und/oder der Lagen (5) aus einer ternären Verbindung, insbesondere einer Al-Ni-W-Verbindung oder Al-Ni-Mo-Verbindung, oder einer quaternären Verbindung, insbesondere Al-Ni-Mo-W, bestehen.

5. Substrat nach einem der vorhergehenden Ansprüche, **dadurch gekennzeichnet, dass** die Matrix zwei verschiedene Lagen (4', 4") aus verschiedenen intermetallischen Phasen umfasst, welche in unterschiedlichen Abständen zum Substrat (1) angeordnet sind.

6. Substrat nach einem der vorhergehenden Ansprüche, **dadurch gekennzeichnet, dass** die zweiten Lagen (5) im Wesentlichen äquidistant innerhalb der Matrix oder innerhalb einer Phase der Matrix ausgebildet sind.

7. Substrat nach einem der vorhergehenden Ansprüche, **dadurch gekennzeichnet, dass** die Matrix bzw. die ersten Lagen (4',4") eine Härte von etwa 350-1100 HV aufweisen.

8. Substrat nach einem der vorhergehenden Ansprüche, **dadurch gekennzeichnet, dass** die Lagen (4',4") aus der ersten Phase eine Dicke zwischen 0,05 µm und 3 µm, vorzugsweise zwischen 0,1 µm und 0,8 µm, aufweisen.

9. Substrat nach einem der vorhergehenden Ansprüche, **dadurch gekennzeichnet, dass** die Lagen (5) aus der zweiten Phase eine Härte von etwa 800 HV und eine Dicke zwischen 0,05 µm und 3 µm, vorzugsweise zwischen 0,1 µm und 0,8 µm, aufweisen.

10. Substrat nach einem der vorhergehenden Ansprüche, **dadurch gekennzeichnet, dass** die Oberfläche (2) des Substrats (1) und/oder das Substrat (1) aus einer Aluminiumlegierung oder Aluminium besteht.

11. Substrat nach einem der vorhergehenden Ansprüche, **dadurch gekennzeichnet, dass** die Oberfläche (2) des Substrats (1) und/oder das Substrat (1) aus einer Nickel-Basislegierung mit einem Anteil an Wolfram und/oder Molybdän besteht.

12. Substrat nach einem der vorhergehenden Ansprüche, **dadurch gekennzeichnet, dass** das Substrat (1) aus einem Stahlwerkstoff besteht.

13. Substrat nach einem der vorhergehenden Ansprüche, **dadurch gekennzeichnet, dass** auf der viellagigen Schichtstruktur (3) eine Aluminiumschicht angeordnet ist.

14. Substrat nach einem der vorhergehenden Ansprüche, **dadurch gekennzeichnet, dass** auf dem Substrat (1) und unter der viellagigen Schichtstruktur (3) eine Nickel-Wolfram-Schicht oder eine Nickel-Molybdän-Schicht oder eine Nickel-Molybdän-Wolfram-Schicht angeordnet ist.

15. Verfahren zur Herstellung einer viellagigen Schichtstruktur (3) aus wenigstens zwei unterschiedlichen Lagen (4, 5) auf einer metallischen Oberfläche (2) eines Substrats (1), wobei die Lagen (4, 5) in periodisch wiederholter Abfolge aufeinander und parallel zur Oberfläche (2) des Substrats (1) angeordnet sind, **dadurch gekennzeichnet, dass** auf die Oberfläche (2) des Substrats (1) wenigstens eine metallische Schicht (6) aufgebracht wird und das beschichtete Substrat (1) einer Wärmebehandlung unterzogen wird und die viellagige Schichtstruktur (3) während der Wärmebehandlung durch Diffusion erzeugt wird, wobei die Werkstoffe der metallischen Schicht (6) und der Oberfläche (2) des Substrats derart aufeinander abgestimmt werden, dass durch die Wärmebehandlung Lagen (4) aus einer ersten, intermetallischen Phase als Matrix ausgebildet werden, in welcher Lagen (5) aus wenigstens einer zweiten, vorzugsweise intermetallischen Phase periodisch ausgebildet werden.

16. Verfahren nach dem vorhergehenden Anspruch, **dadurch gekennzeichnet, dass** für die Werkstoffe der metallischen Schicht (6) und der Oberfläche (2) des Substrats (1) eine Paarung aus Nickel-Wolfram oder Nickel-Molybdän oder Nickel-Molybdän-Wolfram und Aluminium ausgewählt wird.

17. Verfahren nach einem der vorhergehenden Ansprüche, **dadurch gekennzeichnet, dass** die Zeitdauer der Wärmebehandlung derart abgestimmt wird, dass eine intermetallische Matrix bzw. Lagen (4', 4") aus einer einzigen Phase, vorzugsweise aus Al₃Ni₂, erzeugt werden.

18. Verfahren nach einem der vorhergehenden Ansprüche, **dadurch gekennzeichnet, dass** die Zeitdauer der Wärmebehandlung derart abgestimmt wird, dass eine intermetallische Matrix bzw. Lagen (4', 4") aus zwei verschiedenen Phasen, vorzugsweise aus Al₃Ni₂ und Al₃Ni, erzeugt werden.

19. Verfahren nach einem der vorhergehenden Ansprüche, **dadurch gekennzeichnet, dass** die Wärmebehandlung bei einer Temperatur von 400°C -1000°C, vorzugsweise bei 600°C, durchgeführt wird.

20. Verfahren nach einem der vorhergehenden Ansprüche, **dadurch gekennzeichnet, dass** die Wärmebehandlung während eines Herstellprozesses oder während eines Betriebs des Substrats durch die Prozesswärme durchgeführt wird.

21. Verfahren nach einem der vorhergehenden Ansprüche, **dadurch gekennzeichnet, dass** als Substrat (1) eine Aluminiumlegierung oder Aluminium ausgewählt wird, auf das Substrat (1) eine Schicht (6) aus Nickel-Wolfram oder Nickel-Molybdän oder Nickel-Molybdän-Wolfram aufgebracht wird und anschließend das beschichtete Substrat (1) der Wärmebehandlung unterzogen wird.

22. Verfahren nach einem der vorhergehenden Ansprüche, **dadurch gekennzeichnet, dass** als Substrat (1) ein Stahlwerkstoff ausgewählt wird, auf das Substrat eine erste Schicht aus Nickel-Wolfram oder Nickel-Molybdän oder Nickel-Molybdän-Wolfram als Oberfläche (2) und eine zweite Schicht (6) aus Aluminium aufgebracht wird und anschließend das beschichtete Substrat (1) der Wärmebehandlung unterzogen wird.

23. Verfahren nach einem der vorhergehenden Ansprüche, **dadurch gekennzeichnet, dass** auf das Substrat (1) eine erste Schicht als Oberfläche (2) aus Nickel-Wolfram oder Nickel-Molybdän oder Nickel-Molybdän-Wolfram und eine zweite Schicht (6) aus Al aufgebracht wird und das Substrat (1) nach dem Beschichten einer Heißumformung unterzogen wird, wobei die viellagige Schichtstruktur (3) während der Heißumformung erzeugt wird.

24. Verfahren nach einem der vorhergehenden Ansprüche, **dadurch gekennzeichnet, dass** als Substrat (1) eine Nickel-Basislegierung mit einem Anteil an Wolfram und/oder Molybdän gewählt wird, auf das Substrat (1) eine Aluminium-Schicht (6) aufgebracht wird und anschließend das beschichtete Substrat (1) der Wärmebehandlung unterzogen wird.

25. Verfahren nach einem der vorhergehenden Ansprüche, **dadurch gekennzeichnet, dass** die Schicht aus Nickel-Wolfram oder Nickel-Molybdän oder Nickel-Molybdän-Wolfram galvanisch vorzugsweise in einer Schichtstärke von ca. 10 µm - 40 µm, vorzugsweise 15-30 µm, auf das Substrat aufgebracht wird.

26. Verfahren nach einem der vorhergehenden Ansprüche, **dadurch gekennzeichnet, dass** die Aluminiumschicht in einem galvanischen Verfahren, einem MOCVD-Verfahren vorzugsweise in einer Schichtstärke von wenigstens 15 µm aufgebracht wird.
